# DEMANDE DE BREVET EUROPEEN

(11) **EP 1 359 605 A2**
(43) Date de publication de la demande: **05.11.2003**
(21) Numéro de dépôt: 03356072.3
(22) Date de dépôt: 29.04.2003
(51) Int. Cl.: H01L 21/00

(54) **Dispositif d'intégration de système de pompage à vide dans un faux-plancher de salle blanche d'une usine de fabrication de composants semi-conducteurs**

(30) Priorité: 02.05.2002 FR 0205516
(71) Demandeur: ALCATEL, 75008 Paris (FR)
(72) Inventeur: Quinet, Michel, 74370 Naves-Parmelan (FR)
(74) Mandataire: Poncet, Jean-François

(57) **Abrégé**

Selon l'invention, on intègre les systèmes de pompage à vide (15, 16) dans l'espace intermédiaire entre une dalle de soutien (21) et un faux-plancher de salle blanche formé d'une juxtaposition de dalles de faux-plancher (100) tenues par des montants reposant sur la dalle de soutien (21). Un plateau (1), de dimension supérieure à l'encombrement au sol du système de pompage à vide (15, 16) à intégrer, et sensiblement égale à celle d'une dalle de faux-plancher (100), est tenu à l'écart de la dalle de soutien (21) par des pieds (17-20) reposant sur la dalle de soutien (21). On libère ainsi une partie de l'espace au-dessous des systèmes de pompage à vide (15, 16), pour le libre passage de câbles et canalisations. On isole simultanément le système de pompage à vide (15, 16) par rapport au faux-plancher, pour éviter la transmission de vibrations.

## Description

La présente invention concerne les moyens permettant d'intégrer au moins en partie une ligne de pompage à vide dans l'espace intermédiaire situé entre une dalle de soutien et un faux-plancher de salle blanche dans une usine de fabrication de composants semi-conducteurs.

Le sol de la salle blanche d'une usine de fabrication de composants semi-conducteurs est généralement constitué d'un faux-plancher surmontant une dalle de soutien en béton de 90 cm d'épaisseur percée à intervalles réguliers de trous de 80 cm de long et de 40 cm de large. Les trous sont utilisés pour faire passer les canalisations et câbles vers le sous-sol.

Sur cette dalle de soutien sont fixés, avec un maillage de 60 cm, des pieds vérins de hauteur variable suivant les usines, et sur lesquels reposent des dalles de faux-plancher perforées en aluminium de 60 × 60 cm. La hauteur des pieds vérins peut varier entre environ 43 cm et environ 120 cm, suivant les usines. Sur les dalles de faux-plancher sont posés les équipements de fabrication des composants semi-conducteurs. Dans le volume sous les dalles de faux-plancher passent les diverses canalisations et câbles nécessaires au fonctionnement des équipements posés sur le faux-plancher constitué par les dalles de faux-plancher.

On a récemment proposé, par exemple dans le document WO 01/82019, d'intégrer, dans l'espace intermédiaire entre la dalle de soutien et le faux-plancher, une partie au moins de la ligne de vide, par exemple un système de pompage à vide constitué d'une pompe primaire avec éventuellement des dispositifs annexes de traitement de gaz pompés.

L'invention vise à profiter des principaux avantages d'une intégration du système de pompage à vide dans l'espace entre la dalle et le faux-plancher :
- amélioration de la capacité de pompage utile, par rapprochement de la pompe et des chambres à vide situées dans la salle blanche,
- économie de place dans les sous-sols où sont traditionnellement implantées les pompes à vide,
- économie de ligne de pompage, longue et parfois chauffée depuis le sous-sol jusqu'à la machine.

Mais la présence d'un système de pompage à vide dans l'espace intermédiaire entre la dalle de soutien et le faux-plancher perturbe le passage des câbles et canalisations, et risque de générer des vibrations qui sont transmises au faux-plancher et perturbent le fonctionnement des équipements posés sur le faux-plancher. Ces vibrations sont particulièrement néfastes dans le cas où les équipements servent à la fabrication de composants semi-conducteurs, car ils sont source de pollution des tranches de semiconducteur en cours de traitement.

L'invention vise ainsi à éviter en outre les inconvénients pouvant résulter de l'encombrement du système de pompage à vide dans l'espace intermédiaire entre la dalle de soutien et le faux-plancher pour le passage des câbles et canalisations, et à éviter les problèmes liés aux vibrations éventuelles du système de pompage à vide.

Pour cela, l'idée qui est à la base de l'invention consiste à supporter le système de pompage à vide par un plateau support intermédiaire, qui libère une portion d'espace au-dessous du système de pompage à vide pour le passage des câbles et canalisations, et qui isole mécaniquement le système de pompage à vide par rapport au faux-plancher.

Pour atteindre ces buts ainsi que d'autres, l'invention prévoit ainsi un dispositif pour l'intégration d'un système de pompage à vide dans l'espace intermédiaire entre une dalle de soutien et un faux-plancher de salle blanche formé d'une juxtaposition de dalles de faux-plancher tenues par des montants supports de dalles de faux-plancher reposant sur la dalle de soutien, comprenant :
- un plateau, de dimension supérieure à l'encombrement au sol du système de pompage à vide à intégrer et sensiblement égale à celle d'une dalle de faux-plancher,
- des moyens pour tenir le plateau, parallèle et à l'écart de la dalle de soutien, et écarté du faux-plancher d'une hauteur supérieure à la hauteur du système de pompage à vide à intégrer.

Le fait que le dispositif de pompage à vide soit ainsi supporté sous les dalles de faux-plancher permet d'économiser de la place en salle blanche, tout en laissant simultanément un espace libre au-dessous du plateau, espace suffisant pour faire passer les canalisations et câbles nécessaires au fonctionnement des équipements posés sur le faux-plancher.

Deux types de moyen support sont définis pour tenir le plateau.

Selon un premier mode de réalisation, le plateau est soutenu en position par quatre blocs supports ayant chacun une mâchoire en prise sur un montant support de dalle de faux-plancher et ayant une partie de liaison en prise sur le plateau.

Par exemple, la partie de liaison peut comprendre un axe dépassant verticalement vers le haut et s'engageant dans un logement inférieur correspondant du plateau.

Le logement inférieur correspondant du plateau peut être un simple trou ménagé dans la branche centrale d'un profilé en U fixé en sous-face du plateau.

De préférence, le plateau comprend, pour son maintien par quatre blocs supports, trois trous oblongs et un trou rond. De la sorte, on peut positionner correctement le plateau quels que soient les défauts éventuels de positionnement des montants supports de dalle de faux-plancher, ou des autres moyens de support de plateau.

Selon une réalisation avantageuse, évitant les transmissions de vibrations, chaque bloc support comprend une liaison intermédiaire élastique et amortie, qui s'oppose à la transmission des vibrations depuis le système de pompage à vide vers le faux-plancher.

Selon un second mode de réalisation, le plateau est soutenu par quatre pieds qui sont indépendants des moyens de soutien des dalles de faux-plancher et qui reposent sur la dalle de soutien.

Dans ce cas, les pieds comportent de préférence des moyens de réglage en longueur, pour adapter la position verticale du plateau.

Dans les deux modes de réalisation, le plateau peut avantageusement être continu et comporter un rebord périphérique supérieur continu, l'ensemble constituant un bac de rétention de liquide. Le plateau peut alors être associé à un détecteur d'humidité, qui permet de détecter un écoulement liquide pour générer une alarme ou des ordres de commande des équipements dans la salle blanche.

De préférence, le plateau porte un tapis en polymère, interposé entre le plateau et le système de pompage à vide, et réduisant encore les transmissions de vibrations depuis le système de pompage à vide vers le faux-plancher.

Selon un autre aspect, le dispositif de l'invention comprend en outre un portique mobile de levage, à quatre jambes supports ayant des roulettes orientables et ayant une hauteur supérieure à celle d'un système de pompage à vide à intégrer, et à deux traverses à glissières sur lesquelles coulisse un chariot déplaçable portant un treuil.

De préférence, le treuil sollicite un câble qui porte une pièce de liaison en forme de T, raccordée par sa zone centrale réglable à l'extrémité du câble, et comportant des lumières de fixation aux extrémités de ses branches pour l'accrochage du système de pompage à vide.

Le portique mobile de levage permet d'une part de positionner les dispositifs de pompage à vide sur leur plateau, et d'autre part de les extraire de l'espace compris entre la dalle et le faux-plancher, dans les meilleures conditions de sécurité.

Selon un autre aspect, l'invention prévoit une usine de fabrication de semi-conducteurs, comprenant une salle blanche à faux-plancher et dalle de soutien et un système de pompage à vide ; le système de pompage à vide est supporté par un plateau support intermédiaire dans l'espace intermédiaire entre la dalle de soutien et le faux-plancher, libérant une portion d'espace au-dessous du système de pompage à vide pour le passage des câbles et canalisations et isolant mécaniquement le système de pompage à vide par rapport au faux-plancher.

D'autres objets, caractéristiques et avantages de la présente invention ressortiront de la description suivante de modes de réalisation particuliers, faite en relation avec les figures jointes, parmi lesquelles:
- la figure 1 est une vue en perspective illustrant le dispositif d'intégration selon un premier mode de réalisation de la présente invention ;
- la figure 2 est une vue en perspective d'un dispositif d'intégration selon un second mode de réalisation de l'invention, supportant deux systèmes de pompage à vide ;
- la figure 3 est une vue en perspective illustrant les positions possibles des groupes de pompage à vide sur une dalle de soutien ;
- la figure 4 est une vue de dessus illustrant la position relative des dalles de faux-plancher, des ouvertures de la dalle de soutien, et des plateaux supportant les systèmes de pompage à vide ; et
- la figure 5 est une vue en perspective d'un portique mobile de levage selon un mode de réalisation de l'invention.

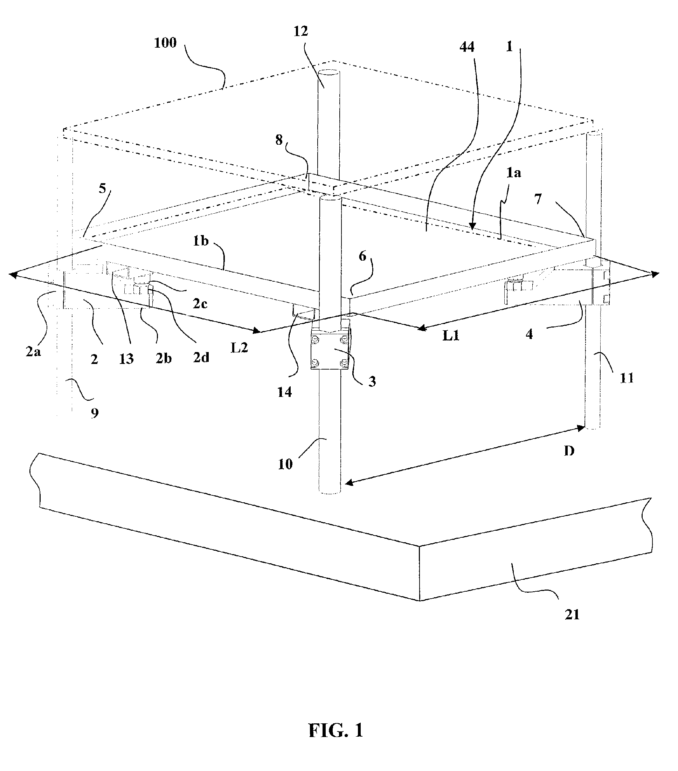

Dans la réalisation illustrée sur la figure 1, le dispositif pour l'intégration d'un système de pompage à vide comprend un plateau 1 rectangulaire, de dimensions supérieures à l'encombrement au sol du système de pompage à intégrer, ces dimensions étant sensiblement égales à celles d'une dalle de faux-plancher 100. Le plateau 1 est soutenu en position par quatre blocs supports, tels que les blocs supports 2, 3 et 4, disposés au voisinage de quatre coins respectifs 5, 6, 7 et 8 du plateau 1 rectangulaire.

Chaque bloc support tel que le bloc support 2 comprend une mâchoire 2a en prise sur un montant support de dalle de faux-plancher respectif tel que les montants 9, 10, 11 et 12 reposant sur la dalle de soutien 21 en béton. Le bloc support 2 comprend une partie de liaison 2b en prise sur le plateau 1.

La partie de liaison 2b comprend un axe 2c qui dépasse verticalement vers le haut pour s'engager dans un logement inférieur correspondant du plateau 1.

Le bloc support 2 comprend en outre une liaison intermédiaire élastique et amortie, qui s'oppose à la transmission des vibrations entre le plateau 1 et le montant support de dalle de faux-plancher 9 correspondant. Par exemple, la liaison intermédiaire élastique et amortie est un silentbloc 2d disposé entre le corps de bloc support 2 et l'axe 2c.

Selon une réalisation avantageuse, car peu onéreuse et efficace, le plateau 1 comprend deux profilés en U 13 et 14, fixés en sous-face du plateau 1, dont la branche centrale se trouve à l'écart du plateau 1 auquel elle est reliée par les deux branches latérales. Le logement inférieur destiné à recevoir l'axe 2c du bloc support 2 est alors un simple trou prévu dans la branche centrale du profilé en U 13.

Dans la réalisation illustrée sur la figure 1, le plateau 1 est maintenu par les trois blocs supports 2, 3 et 4 visibles et par le quatrième bloc non visible sur la figure. Le plateau 1 comprend pour cela trois trous oblongs et un trou rond, recevant les axes respectifs des quatre blocs.

Comme on le voit bien sur la figure 1, le plateau 1 comporte une plaque continue 1a bordée par un rebord périphérique supérieur continu 1b, l'ensemble constituant un bac de rétention de liquide.

Bien que d'autres formes soient possibles et conformes à l'invention, le plateau 1 a avantageusement une forme rectangulaire, avec une largeur L1 légèrement inférieure à la distance D entre deux montants supports de dalles de faux-plancher 10 et 11 successifs, tandis que sa longueur L2 est supérieure à la distance D.

Par exemple, le plateau 1 a une dimension de 650 × 560 mm environ.

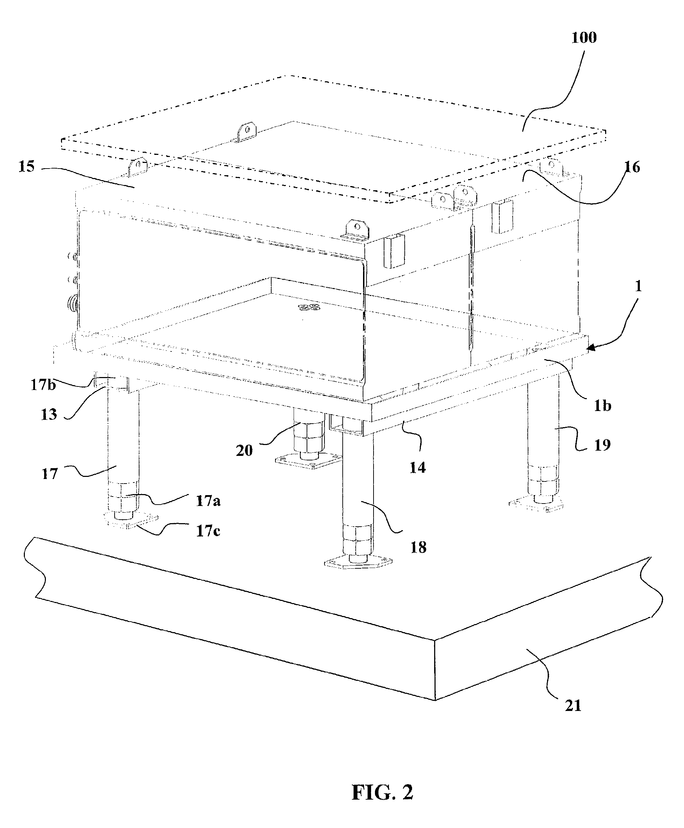

Dans le second mode de réalisation, illustré par exemple sur la figure 2, on retrouve un certain nombre d'éléments du plateau de la figure 1, et ces éléments sont repérés par les mêmes références numériques. On retrouve ainsi le plateau 1 rectangulaire avec son rebord périphérique supérieur continu 1b, ses deux profilés en U 13 et 14 qui eux-mêmes comportent les trous de passage pour des axes verticaux de maintien.

On a représenté sur cette figure deux systèmes de pompage à vide 15 et 16 disposés côte à côte sur le plateau 1.

Le plateau 1 est soutenu par quatre pieds, respectivement 17, 18, 19 et 20, qui sont indépendants des moyens de soutien des dalles de faux-plancher 100, et qui reposent directement sur la dalle de soutien 21. Les pieds 17-20 comportent des moyens de réglage en longueur, par exemple des vérins à vis 17a, pour adapter la position verticale du plateau 1 par rapport à la dalle de soutien 21. Chaque pied 17-20 comporte une extrémité supérieure ayant un axe vertical 17b engagé dans l'un des trous prévus dans les profilés en U 13 ou 14 du plateau 1. Chaque pied 17-20 comporte à sa base une plaque de fixation telle que la plaque 17c, que l'on fixe par vissage ou tout autre moyen sur la dalle de soutien 21.

Les pieds 17-20 sont disposés selon un carré de dimension plus petite que le plateau 1. Par exemple, pour un plateau de dimension 650 × 560 mm environ, les pieds sont disposés selon un carré de 480 mm environ de côté, et en position décentrée par rapport au rectangle constitué par le plateau 1.

Le carré formé par les quatre pieds 17-20 est sensiblement centré selon la largeur du plateau 1, mais décentré selon la longueur.

Dans les deux modes de réalisation, le plateau 1 porte avantageusement un tapis en polymère 44 (figure 1), interposé entre le plateau 1 et le ou les systèmes de pompage à vide 15, 16 (figure 2).

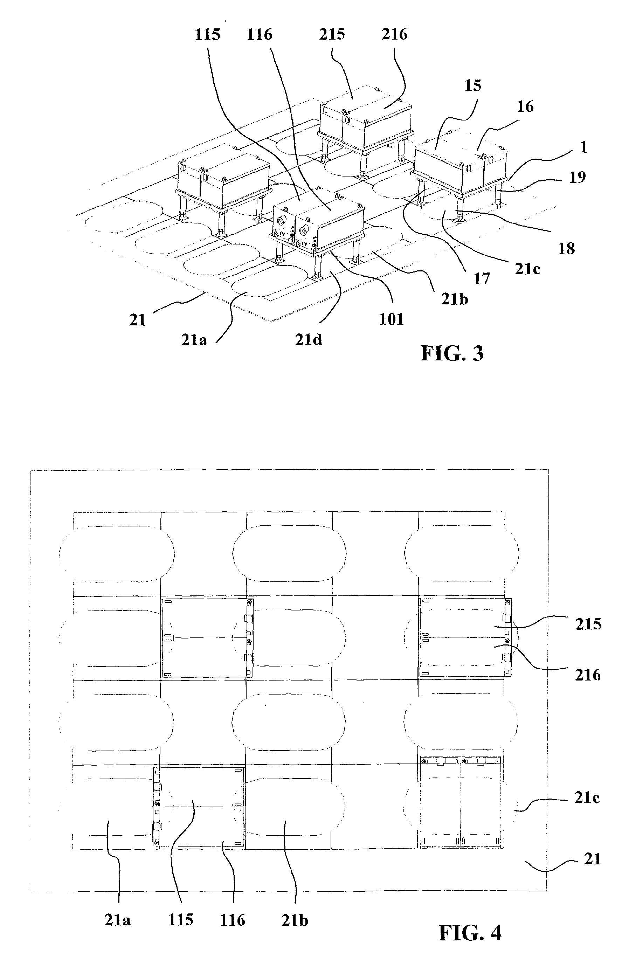

Les figures 3 et 4 illustrent le positionnement relatif d'un ou plusieurs plateaux par rapport aux ouvertures prévues dans la dalle de soutien 21. Ainsi, la dalle de soutien 21, en béton de 90 cm d'épaisseur généralement, est percée à intervalles réguliers de trous ou ouvertures telles que les ouvertures 21a, 21b et 21c, par exemple de 80 cm de long et 40 cm de large, qui sont utilisées pour faire passer les canalisations et câbles entre l'espace supérieur au dessus de la dalle de soutien 21 et l'espace inférieur au dessous de la dalle de soutien 21.

Les figures illustrent trois positionnements possibles pour le ou les systèmes de pompage à vide.

Le premier positionnement est illustré en relation avec les systèmes de pompage à vide 15 et 16, supportés côte à côte sur un plateau 1 lui-même porté par les pieds tels que les pieds 17, 18 19 et 20, et tenus directement au-dessus de l'ouverture 21c de la dalle de soutien 21.

La deuxième disposition est illustrée en relation avec les dispositifs de pompage à vide 115 et 116, portés par un plateau 101 au-dessus d'une zone pleine 21d de la dalle de soutien 21, entre les ouvertures 21a et 21b.

Une troisième disposition est illustrée en relation avec les dispositifs de pompage à vide 215 et 216, disposés au-dessus d'une ouverture mais orientés transversalement par rapport aux précédents systèmes de pompage à vide 15 et 16.

Un avantage de la forme rectangulaire du plateau 1 est de donner une certaine liberté dans le choix de la position horizontale du ou des systèmes de pompage 15 et 16 sur le plateau 1, pour placer le ou les systèmes de pompage 15 et 16 face à une dalle de faux-plancher 100 et dans les deux orientations décrites ci-dessus, quelle que soit la position relative des ouvertures 21a, 21b, 21c.

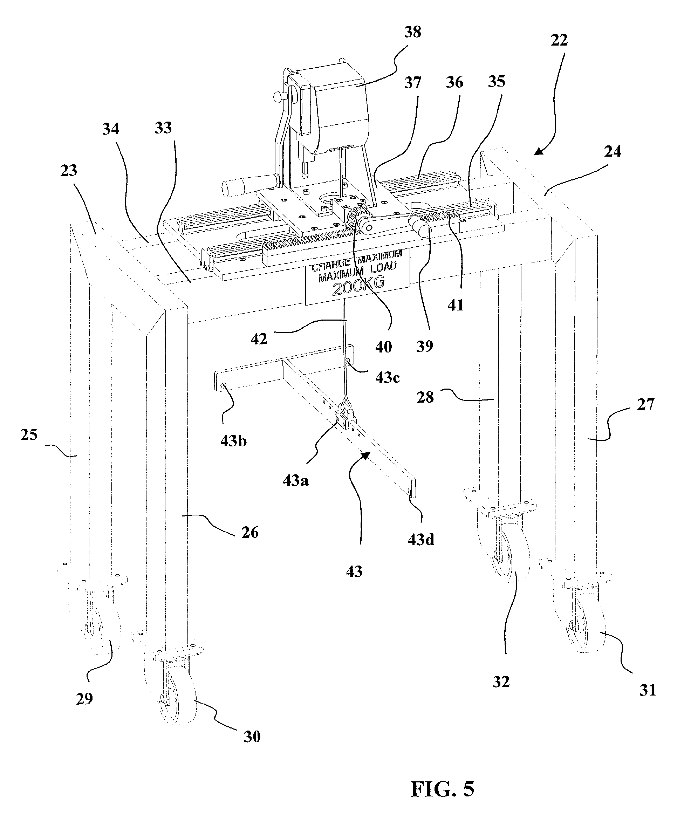

On considère maintenant la figure 5, illustrant en perspective un portique mobile de levage 22, qui permet de positionner les systèmes de pompage à vide sur les plateaux 1 et de les extraire dans des conditions de sécurité satisfaisantes.

Le portique mobile de levage 22 comprend deux longerons 23 et 24 reliant les extrémités supérieures de quatre jambes supports 25, 26, 27 et 28 ayant des roulettes orientables 29, 30, 31, 32. Les roulettes orientables 29 et 32 peuvent être bloquées en pivotement. Les roulettes orientables 30 et 31 peuvent être bloquées en rotation.

Les longerons 23 et 24 sont reliés par deux traverses 33 et 34 portant des glissières 35 et 36 sur lesquelles coulisse un chariot 37 déplaçable portant un treuil 38.

Le chariot 37 peut être déplacé de façon continue par actionnement d'une manivelle 39 entraînant un pignon 40 en prise sur une crémaillère 41.

Le treuil 38 sollicite un câble 42 dont l'extrémité inférieure est fixée à une pièce de liaison 43 en forme de T, comportant elle-même des lumières de fixation 43b, 43c, 43d aux extrémités de ses branches pour l'accrochage d'un système de pompage à vide. Le câble 42 se raccorde à la pièce de liaison 43 en forme de T selon une zone centrale 43a réglable, permettant l'équilibrage.

Le portique mobile de levage 22 est construit avec des matériaux compatibles avec la classe de propreté d'une salle blanche, et ne produit pas de particules. Il forme un châssis enjambeur, dont les dimensions sont choisies de telle manière qu'il peut enjamber une dalle de faux-plancher pour positionner ou extraire un système de pompage et de façon à pouvoir se déplacer aisément entre les divers équipements installés dans la salle blanche.

Le treuil 38 peut lever et descendre le système de pompage à vide en toute sécurité, les roulettes orientables 30 et 31 étant alors bloquées en rotation.

La présente invention n'est pas limitée aux modes de réalisation qui ont été explicitement décrits, mais elle en inclut les diverses variantes et généralisations qui sont à la portée de l'homme du métier.

## Revendications

1. Dispositif pour l'intégration d'un système de pompage à vide (15, 16) dans l'espace intermédiaire entre une dalle de soutien (21) et un faux-plancher de salle blanche formé d'une juxtaposition de dalles de faux-plancher (100) tenues par des montants supports de dalles de faux-plancher (9, 10, 11, 12) reposant sur la dalle de soutien (21), **caractérisé en ce qu'**il comprend :
- un plateau (1), de dimension supérieure à l'encombrement au sol du système de pompage à vide (15, 16) à intégrer et sensiblement égale à celle d'une dalle de faux-plancher (100),
- des moyens pour tenir le plateau (1), parallèle et à l'écart de la dalle de soutien (21), et écarté du faux-plancher d'une hauteur supérieure à la hauteur du système de pompage à vide (15, 16) à intégrer.

2. Dispositif selon la revendication 1, **caractérisé en ce que** le plateau (1) est soutenu en position par quatre blocs supports (2, 3, 4) ayant chacun une mâchoire (2a) en prise sur un montant support de dalle de faux-plancher (9-12) et ayant une partie de liaison (2b) en prise sur le plateau (1).

3. Dispositif selon la revendication 2, **caractérisé en ce que** la partie de liaison (2b) comprend un axe (2c) dépassant verticalement vers le haut et s'engageant dans un logement inférieur correspondant du plateau (1).

4. Dispositif selon la revendication 3, **caractérisé en ce que** le logement inférieur correspondant du plateau (1) est un trou dans la branche centrale d'un profilé en U (13, 14) fixé en sous-face du plateau (1).

5. Dispositif selon la revendication 3, **caractérisé en ce que** le plateau (1) comprend, pour son maintien par quatre blocs supports (2, 3, 4), trois trous oblongs et un trou rond.

6. Dispositif selon l'une quelconque des revendications 2 à 5, **caractérisé en ce que** chaque bloc support (2, 3, 4) comprend une liaison intermédiaire élastique et amortie (2d), s'opposant à la transmission des vibrations depuis le système de pompage à vide (15, 16) vers le faux-plancher (100).

7. Dispositif selon la revendication 1, **caractérisé en ce que** le plateau (1) est soutenu par quatre pieds (17, 18, 19, 20) qui sont indépendants des moyens de soutien (9, 10, 11, 12) des dalles de faux-plancher (100) et qui reposent sur la dalle de soutien (21).

8. Dispositif selon la revendication 7, **caractérisé en ce que** les pieds (17-20) comportent des moyens de réglage en longueur (17a), pour adapter la position verticale du plateau (1).

9. Dispositif selon l'une des revendications 7 ou 8, **caractérisé en ce que** le plateau (1) a une dimension de 650 × 560 mm environ, tandis que les pieds (17-20) sont disposés selon un carré de 480 mm environ de côté et en une position décentrée selon la longueur.

10. Dispositif selon l'une quelconque des revendications 1 à 9, **caractérisé en ce que** le plateau (1) comporte une plaque continue (1a) bordée par un rebord périphérique supérieur continu (1b), l'ensemble constituant un bac de rétention de liquide.

11. Dispositif selon l'une quelconque des revendications 1 à 10, **caractérisé en ce que** le plateau (1) porte un tapis en polymère (44), interposé entre le plateau (1) et le ou les systèmes de pompage à vide (15, 16).

12. Dispositif selon l'une quelconque des revendications 1 à 11, **caractérisé en ce que** le plateau (1) portant un ou deux systèmes de pompage à vide (15, 16) est tenu au-dessus d'une ouverture (21c) de la dalle de soutien (21).

13. Dispositif selon l'une quelconque des revendications 1 à 11, **caractérisé en ce que** le plateau (1, 101) portant un ou deux systèmes de pompage à vide (15, 16, 115, 116) est tenu au-dessus d'une zone pleine (21d) de la dalle de soutien (21), entre les ouvertures (21a, 21b).

14. Dispositif selon l'une quelconque des revendications 1 à 13, **caractérisé en ce qu'**il comprend un portique mobile de levage (22), à quatre jambes supports (25-28) ayant des roulettes orientables (29-32) et ayant une hauteur supérieure à celle d'un système de pompage à vide (15, 16) à intégrer, et à deux traverses (33, 34) à glissières (35, 36) sur lesquelles coulisse un chariot (37) déplaçable portant un treuil (38).

15. Dispositif selon la revendication 14, **caractérisé en ce que** le treuil (38) sollicite un câble (42) qui porte une pièce de liaison (43) en forme de T, raccordée par sa zone centrale réglable (43a) à l'extrémité du câble (42), et comportant des lumières de fixation (43b, 43c, 43d) aux extrémités de ses branches pour l'accrochage du système de pompage à vide (15, 16).

16. Usine de fabrication de semi-conducteurs, comprenant une salle blanche à faux-plancher (100) et dalle de soutien (21) et un système de pompage à vide (15, 16), **caractérisée en ce que** le système de pompage à vide (15, 16) est supporté par un dispositif selon l'une quelconque des revendications 1 à 15, avec un plateau (1) support intermédiaire dans l'espace intermédiaire entre la dalle de soutien (21) et le faux-plancher (100), libérant une portion d'espace au-dessous du système de pompage à vide (15, 16) pour le passage des câbles et canalisations et isolant mécaniquement le système de pompage à vide (15, 16) par rapport au faux-plancher (100).
